# EUROPEAN PATENT SPECIFICATION

(11) **EP 3 121 840 B1**
(45) Date of publication and mention of the grant of the patent: **12.08.2020**
(21) Application number: 15882903.6
(22) Date of filing: 09.10.2015
(51) Int. Cl.: H01L 29/786, H01L 29/45, H01L 29/66, H01L 21/34, H01L 27/12, H01L 21/3213, H01L 21/324, H01L 29/10

(54) **THIN-FILM TRANSISTOR AND PREPARATION METHOD THEREFOR, ARRAY SUBSTRATE, AND DISPLAY PANEL**
DÜNNSCHICHTTRANSISTOR UND HERSTELLUNGSVERFAHREN DAFÜR, ARRAYSUBSTRAT UND ANZEIGETAFEL
TRANSISTOR À COUCHES MINCES ET SON PROCÉDÉ DE PRÉPARATION, SUBSTRAT DE RÉSEAU, ET PANNEAU D'AFFICHAGE

(30) Priority: 08.05.2015 CN 201510232985
(43) Date of publication of application: 25.01.2017
(73) Proprietor: BOE Technology Group Co., Ltd., Chaoyang District, Beijing 100016 (CN); South China University of Technology, Guangdong 510640 (CN)
(72) Inventor: YUAN, Guangcai, Beijing 100176 (CN); YAN, Liangchen, Beijing 100176 (CN); XU, Xiaoguang, Beijing 100176 (CN); WANG, Lei, Guangzhou Guangdong 510640 (CN); PENG, Junbiao, Guangzhou Guangdong 510640 (CN); LAN, Linfeng, Guangzhou Guangdong 510640 (CN)
(74) Representative: AWA Sweden AB
(86) International application number: PCT/CN2015/091540
(87) International publication number: WO 2016/179951

(56) References cited:
- CN-A- 103 972 299
- CN-A- 104 409 515
- CN-A- 104 934 330
- JP-A- H 053 319
- JP-A- 2007 165 473
- JP-A- 2010 027 783
- JP-A- 2015 046 568
- US-A1- 2010 025 678
- US-A1- 2011 263 079

## Description

### TECHNICAL FIELD

This invention relates to the technical field of semiconductors, and particularly to a thin film transistor and the preparation method thereof, an array substrate, and a display panel.

### BACKGROUND ART

Flat panel displays (FPD) have become mainstream products in the market, and the types of flat panel displays are more and more, such as liquid crystal displays(LCDs), organic light-emitting diode (OLED) displays, plasma display panels (PDPs), field emission displays (FEDs), etc.

The thin film transistor (TFT) back panel technology, as the core technology in FPD industry, is also experiencing deep revolution. In particular, with respect to metal oxide thin film transistors (MOTFTs), because of the characteristicsof high mobility (approximately 5 to 50 centimeter²/volt·second), simple manufacture process, relatively low cost, excellent large-area uniformity, etc., the MOTFT technology has attracted a large number of attentions since it brought out.

At present, the structures mainly used in MOTFTs include a back channel etching structure and an etching barrier layer structure. Since the MOTFT of back channel etching structure has a relatively simple manufacture process which is the same as the conventional manufacture process of amorphous silicon and has relatively low equipment investment and production cost, it is considered to be the necessary development direction in which the large-scale mass production and wide utilization of MOTFTs are achieved. In a MOTFT of back channel etching structure, after an active layer is generated, a metal layer is deposited on the active layer and is patterned into a source electrode and a drain electrode. As for an etching barrier layer structure, after an active layer is generated, an etching barrier layer is first produced, and then a metal layer is deposited thereon and is patterned into a source electrode and a drain electrode. However, when the source electrode and the drain electrode are etched on the active layer, the problem of the active layer being corroded, i.e., damage of MOTFT back channel, will occur by using either dry etching or wet etching. For example, when dry etching is used, the active layer composed of metal oxide is prone to be damaged by ions, such that carrier traps are generated on the surface of exposed channels and the concentration of oxygen vacancies increases, resulting in poor device stability. For further example, when wet etching is used, the active layer composed of metal oxide is relatively sensitive to most acidic etching solutions and is prone to be corroded in the process of etching, such that the device performance will be greatly affected. US 210/0025678 discloses an oxide semiconductor thin film transistor with source/drain electrodes formed by a nanopaste.

### SUMMARY OF THE INVENTION

An object of this invention is to provide a thin film transistor and the preparation method thereof, an array substrate, and a display panel, so as to solve the problem in the prior art that the active layer is prone to be corroded when a metal oxide thin film transistor is produced by using a back channel etching process.

The object of this invention is achieved by the following technical solutions.

An embodiment of this invention provides a preparation method of a thin film transistor, according to claim 1.

Preferably, the metal nanoparticle layer is prepared by using at least one material of gold nanoparticles, silver nanoparticles, platinum nanoparticles, beryllium nanoparticles, nickel nanoparticles, and cobalt nanoparticles. In this embodiment, the metal nanoparticle layer is prepared by using gold nanoparticles, silver nanoparticles, platinum nanoparticles, beryllium nanoparticles, nickel nanoparticles, cobalt nanoparticles, or the like, and the active layer can be protected when the source electrode and the drain electrode are subsequently etched, so as to prevent device badness caused by the corrosion of the active layer.

Preferably, the preparation of the metal nanoparticle layer on the active layer specifically comprises:
preparing the metal nanoparticle layer on the active layer by using a physical vapor deposition, a chemical vapor deposition, a hydrothermal method, a sol-gel method, a spray pyrolysis method, or a hot wall method.

Preferably, the metal nanoparticle layer is prepared in a thickness of 1 to 5 nanometers.

Preferably, removing or oxidizing the part of the metal nanoparticle layer which is not covered by the source electrode and the drain electrode is performed by using oxygen plasma.

Preferably, a glass substrate having a buffering layer is used as the base substrate.

Preferably, a flexible substrate having a water-oxygen barrier layer is used as the base substrate, and polyethylene naphthalate, polyethylene terephthalate, a polyimide, or a metal foil is used as the material of the flexible substrate.

Preferably, the gate electrode metal thin film is prepared by using a single film layer of any one of an aluminum thin film, a copper thin film, a molybdenum thin film, a titanium thin film, a silver thin film, a gold thin film, a tantalum thin film, a tungsten thin film, a chromium thin film, and an aluminum alloy thin film, or a composite film layer composed of at least two of the thin films, and the gate electrode metal thin film is prepared in a thickness of 100 to 2000 nanometers.

Preferably, the gate electrode insulating layer is prepared by using a monolayer of a silicon oxide thin film, a silicon nitride thin film, an aluminum oxide thin film, a tantalum pentoxide thin film, or an ytterbium oxide thin film, or the gate electrode insulating layer is prepared by using a composite thin film composed of at least two monolayers of the thin films, and the gate electrode insulating layer is prepared in a thickness of 50 to 500 nanometers.

Preferably, the active layer is prepared by using a metal oxide containing at least one of In, Zn, Ga, and Sn, and the active layer is prepared in a thickness of 10 to 200 nanometers.

Preferably, the source and drain electrode metal thin film is prepared by using a single film layer of any one of an aluminum thin film, a copper thin film, a molybdenum thin film, and a titanium thin film, or a composite film layer composed of at least two or more of the thin films, and the source and drain electrode metal thin film is prepared in a thickness of 100 to 2000 nanometers.

Preferably, the passivation layer may be a single film layer of any one of or a composite film layer composed of at least two or more of silicon oxide, silicon nitride, aluminum oxide, ytterbium oxide, polyimides, benzocyclobutene, or polymethyl methacrylate. Preferably, the passivation layer has a thickness of 50 to 2000 nanometers.

An embodiment of this invention provides a thin film transistor, according to claim 13.

An embodiment of this invention provides an array substrate, comprising the thin film transistor as provided by the above embodiment.

An embodiment of this invention provides a display panel, comprising the array substrate as provided by the above embodiment.

The embodiments of this invention have the advantageous effects as follows. By using the metal nanoparticle layer as a protection layer of the active layer, the active layer may be protected when the source electrode and the drain electrode are etched, so as to prevent device badness caused by the corrosion of the active layer; and at the meanwhile, the metal nanoparticle layer has a good conductivity and good thermal stability, and the requirements for the preparation process of the metal oxide thin film transistor are relatively low, such that the preparation of the metal oxide thin film transistor by a simple process and a low cost is achieved.

### DESCRIPTION OF THE DRAWINGS

Fig. 1 is a flow chart of a preparation method of a metal oxide thin film transistor provided by an embodiment of this invention;
Fig. 2 is a structural schematic diagram of the metal oxide thin film transistor in which the gate electrode is prepared in an embodiment of this invention;
Fig. 3 is a structural schematic diagram of the metal oxide thin film transistor in which the gate electrode insulating layer is prepared in an embodiment of this invention;
Fig. 4 is a structural schematic diagram of the metal oxide thin film transistor in which the active layer is prepared in an embodiment of this invention;
Fig. 5 is a structural schematic diagram of the metal oxide thin film transistor in which the metal nanoparticle layer is prepared in an embodiment of this invention;
Fig. 6 is a structural schematic diagram of the metal oxide thin film transistor in which the source and drain electrode metal thin film is prepared in an embodiment of this invention;
Fig. 7 is a structural schematic diagram of the metal oxide thin film transistor in which the source electrode and the drain electrode are prepared in an embodiment of this invention;
Fig. 8 is a structural schematic diagram of the metal oxide thin film transistor in which the metal nanoparticle layer not covered by the source electrode and the drain electrode is removed in an embodiment of this invention;
Fig. 9 is a structural schematic diagram of the metal oxide thin film transistor in which the passivation layer is prepared in an embodiment of this invention.

### DESCRIPTION OF EMBODIMENTS

The processes for achieving embodiments of this invention are described below in detail in conjunction with the accompanying drawings. It is to be noted that the same or similar numerals represent the same or similar elements or elements having the same or similar functions throughout. The embodiments described below with reference to the accompanying drawings are exemplary and are merely used for explaining the present invention, and cannot be construed to be limitations of this invention.

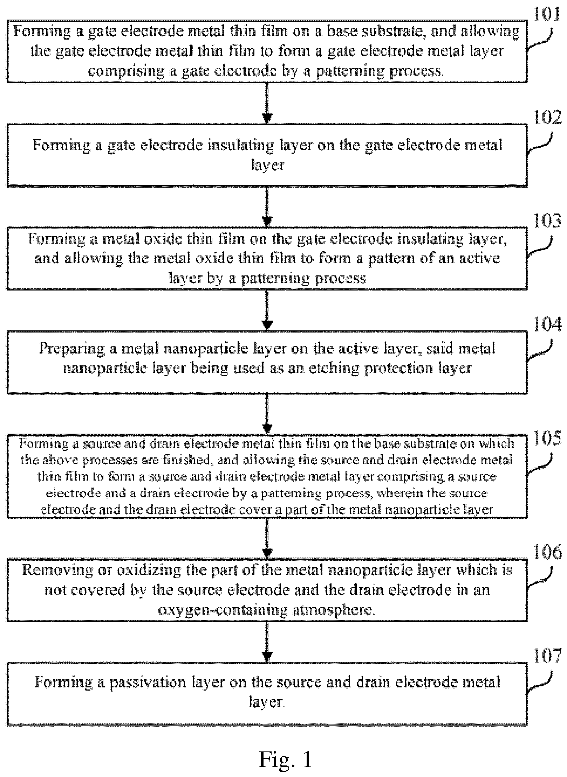

With reference to Fig. 1, an embodiment of this invention provides a preparation method of a thin film transistor, comprising:
101, forming a gate electrode metal thin film on a base substrate, and allowing the gate electrode metal thin film to form a gate electrode metal layer comprising a gate electrode by a patterning process.

According to different particular applications of the metal oxide thin film transistor, a glass substrate having a buffering layer may be used as the base substrate, and a flexible substrate having a water-oxygen barrier layer may also be used as the base substrate, preferably, polyethylene naphthalate, polyethylene terephthalate, a polyimide, or a metal foil is used as the material of the flexible substrate. Preferably, a SiO₂ buffering layer or a Si₃N₄ layer is used as the buffering layer on the glass substrate. Preferably, an Al₂O₃ layer, a Si₃N₄ layer, a SiCN layer, a SiOₓ layer, a SiON layer, and a stacked composite structure thereof may be used as the water-oxygen barrier layer.

Preferably, the gate electrode metal thin film is prepared by using a single film layer of any one of an aluminum thin film, a copper thin film, a molybdenum thin film, a titanium thin film, a silver thin film, a gold thin film, a tantalum thin film, a tungsten thin film, a chromium thin film, and an aluminum alloy thin film, or a composite film layer composed of at least two of the thin films, and the gate electrode metal thin film is prepared in a thickness of 100 to 2000 nanometers.

102, forming a gate electrode insulating layer on the gate electrode metal layer.

Preferably, the gate electrode insulating layer is prepared by using a monolayer of a silicon oxide thin film, a silicon nitride thin film, an aluminum oxide thin film, a tantalum pentoxide thin film, or an ytterbium oxide thin film, or the gate electrode insulating layer is prepared by using a composite thin film composed of at least two monolayers of the thin films, and the gate electrode insulating layer is prepared in a thickness of 50 to 500 nanometers.

103, forming a metal oxide thin film on the gate electrode insulating layer, and allowing the metal oxide thin film to form a pattern of an active layer by a patterning process.

Preferably, the active layer is prepared by using a metal oxide containing at least one of In, Zn, Ga, and Sn, and the active layer is prepared in a thickness of 10 to 200 nanometers.

104, preparing a metal nanoparticle layer on the active layer, said metal nanoparticle layer being used as an etching protection layer.

Specifically, the metal nanoparticle layer may be deposited by using a process such as a physical vapor deposition, a chemical vapor deposition, a hydrothermal method, a sol-gel method, a spray pyrolysis method, a hot wall method, etc.

The metal nanoparticle layer is prepared by using at least one material of gold nanoparticles, silver nanoparticles, platinum nanoparticles, beryllium nanoparticles, nickel nanoparticles, and cobalt nanoparticles. Preferably, the metal nanoparticle layer is prepared in a thickness of 1 to 5 nanometers. Of course, in view of cost, one or more of beryllium nanoparticles, nickel nanoparticles, and cobalt nanoparticles having lower cost may also be used for the metal nanoparticle layer.

It is to be indicated that after the metal nanoparticle layer is deposited, it may further comprise a process of performing annealing treatment on the metal nanoparticle layer.

In this embodiment, the active layer can be protected by the metal nanoparticle layer when the source electrode and the drain electrode are etched, so as to prevent device badness caused by the corrosion of the active layer.

105, forming a source and drain electrode metal thin film on the base substrate on which the above processes are finished, allowing the source and drain electrode metal thin film to form a source and drain electrode metal layer comprising a source electrode and a drain electrode by a patterning process, wherein the source electrode and the drain electrode cover a part of the metal nanoparticle layer.

Preferably, the source and drain electrode metal thin film is prepared by using a single film layer of any one of an aluminum thin film, a copper thin film, a molybdenum thin film, and a titanium thin film, or a composite film layer composed of at least two of the thin films, and the source and drain electrode metal thin film is prepared in a thickness of 100 to 2000 nanometers.

106, removing or oxidizing the part of the metal nanoparticle layer which is not covered by the source electrode and the drain electrode in an oxygen-containing atmosphere.

Preferably, removing or oxidizing the part of the metal nanoparticle layer which is not covered by the source electrode and the drain electrode is performed by using oxygen plasma.

107, forming a passivation layer on the source and drain electrode metal layer.

Preferably, the passivation layer is prepared by using a single film layer of any one of silicon oxide, silicon nitride, aluminum oxide, ytterbium oxide, polyimides, benzocyclobutene, and polymethyl methacrylate, or a composite film layer composed of at least two of silicon oxide, silicon nitride, aluminum oxide, ytterbium oxide, polyimides, benzocyclobutene, and polymethyl methacrylate, and the passivation layer is prepared in a thickness of 50 to 2000 nanometers.

It is to be indicated that a method for protecting the active layer by using an organic conductive thin film in a back channel etching process of a metal oxide thin film transistor is also provided in the prior art, but the conductivity of silicon or carbon in the organic conductive thin film is relatively poor, which may lead to bad contact of the active layer with the source electrode and the drain electrode, such that the metal oxide thin film transistor is instable; and at the meanwhile, the thermal stability of the organic conductive thin film is poor and will be decomposed in subsequent procedures, resulting in instable or bad metal oxide thin film transistors, and the decomposed organic conductive thin film may contaminate the preparation equipment. Compared to the organic conductive thin film, the metal nanoparticle layer has a better thermal stability, is capable of protecting the active layer, enables the metal oxide thin film transistor thus prepared to be more stable, and will not contaminate the preparation equipment.

The embodiments of this invention have the advantageous effects as follows. By using the metal nanoparticle layer as a protection layer of the active layer, the active layer can be protected when the source electrode and the drain electrode are etched, so as to prevent device badness caused by the corrosion of the active layer; and at the meanwhile, the metal nanoparticle layer has a good conductivity and is favorable to the achievement of good conductive contact with the source electrode and the drain electrode; the metal nanoparticle layer has a better thermal stability compared to the organic conductive thin film, and the requirements for the preparation process of the metal oxide thin film transistor are relatively low, such that the preparation of the metal oxide thin film transistor by a simple process and a low cost is achieved.

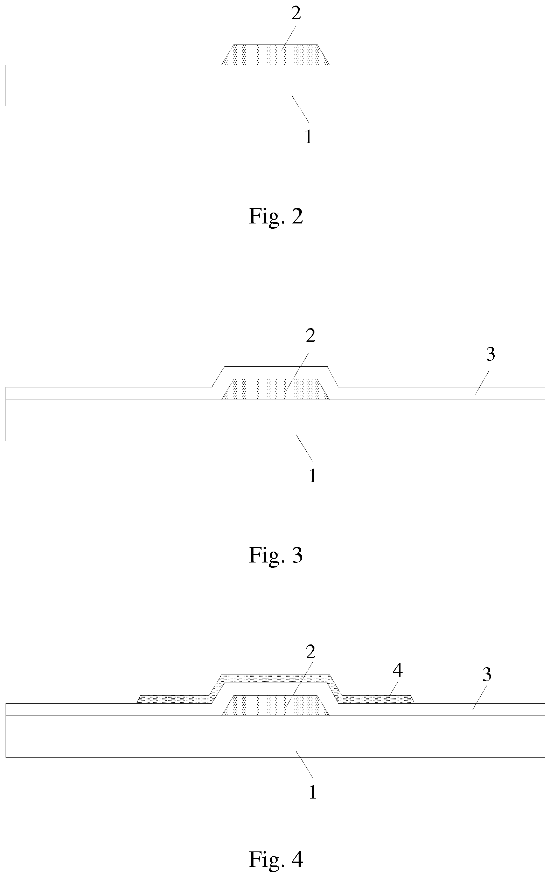

In order to describe the preparation method of the metal oxide thin film transistor provided by this invention in more detail, embodiments are provided in conjunction with Fig. 2 to Fig. 9 as follows.

### Embodiment 1

This embodiment of this invention provides a first particular preparation method of a metal oxide thin film transistor, comprising:
Step 1, depositing three layers of metal thin films of molybdenum/aluminum /molybdenum as a gate electrode metal thin film on a base substrate 1 by using a physical vapor deposition method, wherein the three layers of metal thin films of molybdenum/aluminum/molybdenum have thicknesses of 25/100/25 nanometers respectively, and allowing the gate electrode metal thin film to form a gate electrode 2 by a patterning process. The base substrate 1 is an alkali-free glass substrate with a SiO₂ buffering layer having a thickness of 200 nanometers. The schematic diagram after the gate electrode 2 is prepared on the base substrate 1 is shown in Fig. 2.

Step 2, depositing a gate electrode insulating layer 3 by using a plasma enhanced chemical vapor deposition method, on the base substrate 1 on which the above step is finished. The schematic diagram after the gate electrode insulating layer 3 is prepared is shown in Fig. 3.

The gate electrode insulating layer 3 is formed by laminating 300-nanometer SiNₓ and 30-nanometer SiO₂.

Step 3, depositing a metal oxide thin film on the gate electrode insulating layer 3 by using a physical vapor deposition method, and allowing the metal oxide thin film to form a pattern of an active layer 4 by a patterning process. The metal oxide thin film is an indium zinc oxide (IZO) thin film, wherein the atomic ratio of indium to zinc is 1:1. The schematic diagram in which the active layer 4 is prepared is shown in Fig. 4.

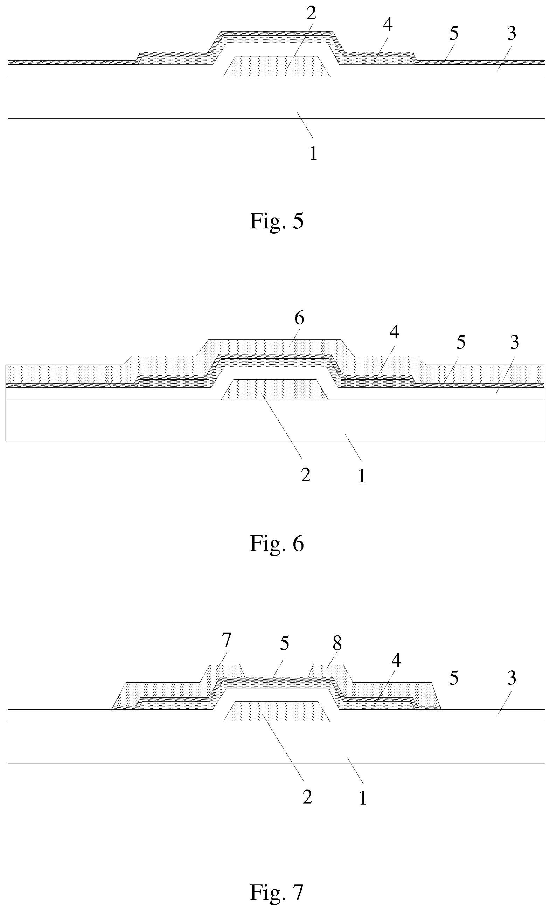

Step 4, depositing a gold nanoparticle layer having a thickness of 5 nanometers as a metal nanoparticle layer 5 on the active layer 4 by using a physical vapor deposition method. The schematic diagram in which the metal nanoparticle layer 5 is prepared is shown in Fig. 5.

The active layer 4 can be protected by the metal nanoparticle layer 5 when the source electrode 7 and the drain electrode 8 (as shown in Fig. 7) are subsequently etched, so as to prevent the badness of the metal oxide thin film transistor caused by the corrosion of the active layer 4.

It is to be indicated that it may further comprise a process of annealing the metal nanoparticle layer 5 in Step 4.

Step 5, depositing laminated layers of molybdenum/aluminum/molybdenum, which have thicknesses of 25/100/25 nanometers respectively, as a source and drain electrode metal thin film 6 on the base substrate 1 on which the above processes are finished, by using a physical vapor deposition method. The schematic diagram in which the source and drain electrode metal thin film 6 is prepared is shown in Fig. 6.

A mixed solution of 30% H₂O₂ and 1% KOH is used as a wet etching solution for etching the source and drain electrode metal thin film 6 to form a source electrode 7 and a drain electrode 8, wherein the source electrode 7 and the drain electrode 8 cover a part of the metal nanoparticle layer 5. The schematic diagram in which the source electrode 7 and the drain electrode 8 are prepared is shown in Fig. 7.

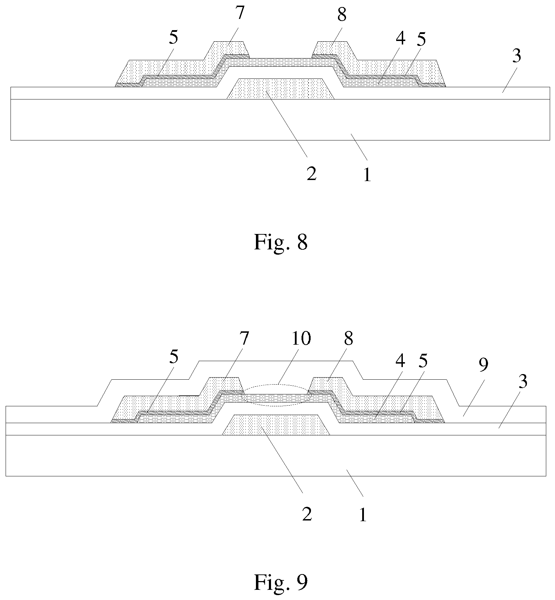

Step 6, removing the part of the metal nanoparticle layer 5 which is not covered by the source electrode 7 and the drain electrode 8 by using oxygen plasma. The schematic diagram after the part of the metal nanoparticle layer 5 not covered by the source electrode 7 and the drain electrode 8 is removed is shown in Fig. 8.

Step 7, depositing 300-nanometer SiO₂ as a passivation layer 9 on the base substrate 1 on which the above processes are finished, by using a plasma enhanced chemical vapor deposition method, i.e., forming a passivation layer 9 on the source and drain electrode metal layer comprising the source electrode 7 and the drain electrode 8. The schematic diagram in which the passivation layer 9 is prepared is shown in Fig. 9.

It is practically found that the protection of the active layer 4 in the back channel etching process by using the metal nanoparticle layer 5 is more stable compared to the protection by an organic conductive thin film, and the metal nanoparticle layer 5 has a good conductivity, large surface roughness, and is very favorable to the achievement of good contact of the active layer 4 with the source electrode 7 and the drain electrode 8.

### Embodiment 2

This embodiment of this invention provides a second particular preparation method of a metal oxide thin film transistor, comprising:
Step 1, depositing a copper metal thin film as a gate electrode metal thin film on a base substrate 1 by using a physical vapor deposition method, wherein the copper metal thin film has a thickness of 500 nanometers, and allowing the gate electrode metal thin film to form a gate electrode 2 by a patterning process. The base substrate 1 is a flexible substrate with a water-oxygen barrier layer of Al₂O₃ having a thickness of 50 nanometers. The schematic diagram after the gate electrode 2 is prepared on the base substrate 1 is shown in Fig. 2.

Step 2, depositing a gate electrode insulating layer 3 by using a plasma enhanced chemical vapor deposition method, on the base substrate 1 on which the above step is finished. The schematic diagram after the gate electrode insulating layer 3 is prepared is shown in Fig. 3.

The gate electrode insulating layer 3 is formed by laminating 200-nanometer aluminum oxide and 100-nanometer ytterbium oxide.

Step 3, depositing a metal oxide thin film on the gate electrode insulating layer 3 by using a physical vapor deposition method, and allowing the metal oxide thin film to form a pattern of an active layer 4 by a patterning process. The metal oxide thin film is an 80-nanometer indium gallium zinc oxide (IGZO) thin film, wherein the atomic ratio of indium, gallium, and zinc is 1:1:1. The schematic diagram in which the active layer 4 is prepared is shown in Fig. 4.

Step 4, preparing a nickel nanoparticle layer having a thickness of 2 nanometers as a metal nanoparticle layer 5 on the active layer 4, by using a spray pyrolysis method. The schematic diagram in which the metal nanoparticle layer 5 is prepared is shown in Fig. 5.

The active layer 4 can be protected by the metal nanoparticle layer 5 when the source electrode 7 and the drain electrode 8 (as shown in Fig. 7) are subsequently etched, so as to prevent the badness of the metal oxide thin film transistor caused by the corrosion of the active layer 4.

It is to be indicated that it may further comprise a process of annealing the metal nanoparticle layer 5 in Step 4.

Step 5, depositing a copper metal thin film having a thicknesses of 500 nanometers as a source and drain electrode metal thin film 6 on the base substrate 1 on which the above processes are finished, by using a physical vapor deposition method. The schematic diagram in which the source and drain electrode metal thin film 6 is prepared is shown in Fig. 6.

A mixed solution of H₂O₂ and H₂SO₄ is used as a wet etching solution for etching the source and drain electrode metal thin film 6 to form a source electrode 7 and a drain electrode 8, wherein the source electrode 7 and the drain electrode 8 cover a part of the metal nanoparticle layer 5. The schematic diagram in which the source electrode 7 and the drain electrode 8 are prepared is shown in Fig. 7.

Step 6, removing the part of the metal nanoparticle layer 5 which is not covered by the source electrode 7 and the drain electrode 8 by using oxygen plasma. The schematic diagram after the part of the metal nanoparticle layer 5 not covered by the source electrode 7 and the drain electrode 8 is removed is shown in Fig. 8.

Step 7, depositing 800-nanometer polyimide as a passivation layer 9 on the base substrate 1 on which the above processes are finished, by using a plasma enhanced chemical vapor deposition method, i.e., forming a passivation layer 9 on the source and drain electrode metal layer comprising the source electrode 7 and the drain electrode 8. The schematic diagram in which the passivation layer 9 is prepared is shown in Fig. 9.

It is practically found that the protection of the active layer 4 in the back channel etching process by using the metal nanoparticle layer 5 is more stable compared to the protection by an organic conductive thin film, and the metal nanoparticle layer has a good conductivity, a rough surface, and is very favorable to the achievement of good contact of the active layer 4 with the source electrode 7 and the drain electrode 8.

### Embodiment 3

This embodiment of this invention provides a third particular preparation method of a metal oxide thin film transistor, comprising:
Step 1, depositing an ITO thin film as a gate electrode metal thin film on a base substrate 1 by using a physical vapor deposition method, wherein the ITO thin film has a thickness of 200 nanometers, and allowing the gate electrode metal thin film to form a gate electrode 2 by a patterning process. The base substrate 1 is a flexible substrate with a water-oxygen barrier layer of Si₃N₄ having a thickness of 200 nanometers. The schematic diagram after the gate electrode 2 is prepared on the base substrate 1 is shown in Fig. 2.

Step 2, depositing a gate electrode insulating layer 3 by using a plasma enhanced chemical vapor deposition method on the base substrate 1 on which the above step is finished. The schematic diagram after the gate electrode insulating layer 3 is prepared is shown in Fig. 3.

The gate electrode insulating layer 3 is formed by laminating 100-nanometer silicon oxide, 90-nanometer tantalum pentoxide, and 20-nanometer silicon dioxide.

Step 3, depositing a metal oxide thin film on the gate electrode insulating layer 3 by using a physical vapor deposition method, and allowing the metal oxide thin film to form a pattern of an active layer 4 by a patterning process. The metal oxide thin film is a 50-nanometer IZO thin film, wherein the atomic ratio of indium to zinc is 1:1. The schematic diagram in which the active layer 4 is prepared is shown in Fig. 4.

Step 4, preparing a silver nanoparticle layer having a thickness of 3 nanometers as a metal nanoparticle layer 5 on the active layer 4 by using a solution treatment method. The schematic diagram in which the metal nanoparticle layer 5 is prepared is shown in Fig. 5.

The active layer 4 can be protected by the metal nanoparticle layer 5 when the source electrode 7 and the drain electrode 8 (as shown in Fig. 7) are subsequently etched, so as to prevent the badness of the metal oxide thin film transistor caused by the corrosion of the active layer 4.

It is to be indicated that it may further comprise a process of annealing the metal nanoparticle layer 5 in Step 4.

Step 5, depositing a copper metal thin film, which is a monolayer thin film and has a thicknesses of 200 nanometers, as a source and drain electrode metal thin film 6 on the base substrate 1 on which the above processes are finished, by using a physical vapor deposition method. The schematic diagram in which the source and drain electrode metal thin film 6 is prepared is shown in Fig. 6.

A mixed solution of H₂O₂ and H₂SO₄ is used as a wet etching solution for etching the source and drain electrode metal thin film 6 to form a source electrode 7 and a drain electrode 8, wherein the source electrode 7 and the drain electrode 8 cover a part of the metal nanoparticle layer 5. The schematic diagram in which the source electrode 7 and the drain electrode 8 are prepared is shown in Fig. 7.

Step 6, removing the part of the metal nanoparticle layer 5 which is not covered by the source electrode 7 and the drain electrode 8 by using oxygen plasma. The schematic diagram after the part of the metal nanoparticle layer 5 not covered by the source electrode 7 and the drain electrode 8 is removed is shown in Fig. 8.

Step 7, depositing 300-nanometer SiO₂ as a passivation layer 9 on the base substrate 1 on which the above processes are finished, by using a plasma enhanced chemical vapor deposition method, i.e., forming a passivation layer 9 on the source and drain electrode metal layer comprising the source electrode 7 and the drain electrode 8. The schematic diagram in which the passivation layer 9 is prepared is shown in Fig. 9.

It is practically found that the protection of the active layer 4 in the back channel etching process by using the metal nanoparticle layer 5 is more stable compared to the protection by an organic conductive thin film, and the metal nanoparticle layer has a good conductivity, a rough surface, and is very favorable to the achievement of good contact of the active layer 4 with the source electrode 7 and the drain electrode 8.

The above embodiments 1 to 3 are merely a part of specific embodiments provided to illustrate this invention, and this invention is not limited thereto. The prepared metal oxide thin film transistors may be used in liquid crystal displays and active matrix organic light-emitting diode displays. Thicknesses of thin films, constituent materials, proportioning ratios, etc., involved in each step in embodiments 1 to 3 may be adjusted according to practical requirements.

As shown in Fig. 9, one embodiment of this invention further provides a thin film transistor, which is a metal oxide thin film transistor, comprising:
a base substrate 1;
a gate electrode metal layer formed on the base substrate 1, wherein the gate electrode metal layer comprises a gate electrode 2;
a gate electrode insulating layer 3 formed on the gate electrode metal layer;
an active layer 4 formed on the gate electrode insulating layer;
a metal nanoparticle layer 5 formed on the active layer 4, wherein the metal nanoparticle layer 5 is used as an etching protection layer;
a source and drain electrode metal layer formed on the metal nanoparticle layer 5, wherein the source and drain electrode metal layer comprises a source electrode 7 and a drain electrode 8; and
a passivation layer 9 formed on the source and drain electrode metal layer.

It is to be indicated that the part indicated by the dashed frame 10 is the removed part of metal nanoparticle layer 5, which is removed after the source electrode 7 and the drain electrode 8 are formed. This part of the metal nanoparticle layer 5, which should be removed, can protect the active layer 4 when the source electrode 7 and the drain electrode 8 are prepared. The metal nanoparticle layer 5 comprises at least one material of gold nanoparticles, silver nanoparticles, platinum nanoparticles, beryllium nanoparticles, nickel nanoparticles, and cobalt nanoparticles.

Preferably, the metal nanoparticle layer 5 has a thickness of 1 to 5 nanometers.

Preferably, the base substrate 1 is a glass substrate having a buffering layer.

Preferably, the base substrate 1 is a flexible substrate having a water-oxygen barrier layer, and the material of the flexible substrate is polyethylene naphthalate, polyethylene terephthalate, a polyimide, or a metal foil.

Preferably, the gate electrode metal layer is a single film layer of any one of an aluminum thin film, a copper thin film, a molybdenum thin film, a titanium thin film, a silver thin film, a gold thin film, a tantalum thin film, a tungsten thin film, a chromium thin film, and an aluminum alloy thin film, or a composite film layer composed of at least two of the thin films, and the gate electrode metal layer has a thickness of 100 to 2000 nanometers. It is to be indicated that the material and the thickness of the gate electrode metal layer herein are those of the gate electrode metal thin film in the preparation method.

Preferably, the gate electrode insulating layer 3 is a monolayer of a silicon oxide thin film, a silicon nitride thin film, an aluminum oxide thin film, a tantalum pentoxide thin film, or an ytterbium oxide thin film, or the gate electrode insulating layer 3 is a composite thin film composed of at least two monolayers of the thin films, and the gate electrode insulating layer 3 has a thickness of 50 to 500 nanometer.

Preferably, the active layer 4 contains a metal oxide of at least one of In, Zn, Ga, and Sn, the active layer 4 has a thickness of 10 to 200 nanometers. The source and drain electrode metal layer is a single film layer of any one of an aluminum thin film, a copper thin film, a molybdenum thin film, and a titanium thin film, or a composite film layer composed of at least two of the thin films, the source and drain electrode metal layer has a thickness of 100 to 2000 nanometers. It is to be indicated that the material and the thickness of the source and drain electrode metal layer herein are those of the source and drain electrode metal thin film in the preparation method.

Preferably, the passivation layer 9 may be a single film layer of any one of silicon oxide, silicon nitride, aluminum oxide, ytterbium oxide, polyimides, benzocyclobutene, and polymethyl methacrylate, or a composite film layer composed of at least two of silicon oxide, silicon nitride, aluminum oxide, ytterbium oxide, polyimides, benzocyclobutene, and polymethyl methacrylate. Preferably, the passivation layer 9 has a thickness of 50 to 2000 nanometers.

The embodiment of this invention has the advantageous effects as follows. By using the metal nanoparticle layer as a protection layer of the active layer, the active layer can be protected when the source electrode and the drain electrode are etched, so as to prevent device badness caused by the corrosion of the active layer; and at the meanwhile, the metal nanoparticle layer has a good conductivity and good thermal stability, and the requirements for the preparation process of the metal oxide thin film transistor are relatively low, such that the preparation of the metal oxide thin film transistor by a simple process and a low cost is achieved.

Based on the same inventive concept, one embodiment of this invention further provides an array substrate, comprising the thin film transistor as provided by the above embodiment.

The embodiment of this invention has the advantageous effects as follows. In this array substrate, the metal oxide thin film transistor uses the metal nanoparticle layer as a protection layer of the active layer, and the active layer can be protected when the source electrode and the drain electrode are etched, so as to prevent device badness caused by the corrosion of the active layer; and at the meanwhile, the metal nanoparticle layer has a good conductivity and good thermal stability, and the requirements for the preparation process of the metal oxide thin film transistor are relatively low, such that the preparation of the metal oxide thin film transistor by a simple process and a low cost is achieved.

Based on the same inventive concept, one embodiment of this invention provides a display panel, comprising the array substrate as provided by the above embodiment.

The embodiment of this invention has the advantageous effects as follows. In the array substrate used by the display panel, the metal oxide thin film transistor uses the metal nanoparticle layer as a protection layer of the active layer, and the active layer can be protected when the source electrode and the drain electrode are etched, so as to prevent device badness caused by the corrosion of the active layer; and at the meanwhile, the metal nanoparticle layer has a good conductivity and good thermal stability, and the requirements for the preparation process of the metal oxide thin film transistor are relatively low, such that the preparation of the metal oxide thin film transistor by a simple process and a low cost is achieved.

## Claims

1. A preparation method of a thin film transistor, **characterized by** comprising:
forming a gate electrode metal thin film on a base substrate (1), and allowing the gate electrode metal thin film to form a gate electrode metal layer comprising a gate electrode (2) by a patterning process;
forming a gate electrode insulating layer (3) on the gate electrode metal layer;
forming a metal oxide thin film on the gate electrode insulating layer (3), and allowing the metal oxide thin film to form a pattern of an active layer (4) by a patterning process;
preparing a metal nanoparticle layer (5) on the active layer (4);
forming a source and drain electrode metal thin film (6) on the base substrate on which the above processes are finished, and allowing the source and drain electrode metal thin film (6) to form a source and drain electrode metal layer comprising a source electrode (7) and a drain electrode (8) by a patterning process, wherein the metal nanoparticle layer (5) is used as an etching protection layer when the source and drain electrode metal thin film (6) is etched, and the resultant source electrode (7) and drain electrode (8) cover a part of the metal nanoparticle layer (5);
removing or oxidizing the part of the metal nanoparticle layer (5) which is not covered by the source electrode (7) and the drain electrode (8) in an oxygen-containing atmosphere; and
forming a passivation layer (9) on the source and drain electrode metal layer (6).

2. The preparation method as claimed in claim 1, **characterized in that** the metal nanoparticle layer (5) is prepared by using at least one material of gold nanoparticles, silver nanoparticles, platinum nanoparticles, beryllium nanoparticles, nickel nanoparticles, and cobalt nanoparticles.

3. The preparation method as claimed in claim 2, **characterized in that** preparing the metal nanoparticle layer (5) on the active layer comprises:
preparing the metal nanoparticle layer (5) on the active layer (4) by using a physical vapor deposition, a chemical vapor deposition, a hydrothermal method, a sol-gel method, a spray pyrolysis method, or a hot wall method.

4. The preparation method as claimed in claim 2, **characterized in that** the metal nanoparticle layer (5) is prepared in a thickness of 1 to 5 nanometers.

5. The preparation method as claimed in any one of claims 1 to 4, **characterized in that** a glass substrate having a buffering layer is used as the base substrate (1).

6. The preparation method as claimed in any one of claims 1 to 4, **characterized in that** a flexible substrate having a water-oxygen barrier layer is used as the base substrate (1), and polyethylene naphthalate, polyethylene terephthalate, a polyimide, or a metal foil is used as the material of the flexible substrate.

7. The preparation method according to any one of claims 1 to 4, **characterized in that** the gate electrode metal thin film is prepared by using a single film layer of any one of an aluminum thin film, a copper thin film, a molybdenum thin film, a titanium thin film, a silver thin film, a gold thin film, a tantalum thin film, a tungsten thin film, a chromium thin film, and an aluminum alloy thin film, or a composite film layer composed of at least two of the thin films, and the gate electrode metal thin film is prepared in a thickness of 100 to 2000 nanometers.

8. The preparation method according to any one of claims 1 to 4, **characterized in that** the gate electrode insulating layer (3) is prepared by using a monolayer of a silicon oxide thin film, a silicon nitride thin film, an aluminum oxide thin film, a tantalum pentoxide thin film, or an ytterbium oxide thin film, or the gate electrode insulating layer (3) is prepared by using a composite thin film composed of at least two monolayers of the thin films, and the gate electrode insulating layer (3) is prepared in a thickness of 50 to 500 nanometers.

9. The preparation method according to any one of claims 1 to 4, **characterized in that** the active layer (4) is prepared by using a metal oxide containing at least one of In, Zn, Ga, and Sn, and the active layer (4) is prepared in a thickness of 10 to 200 nanometers.

10. The preparation method according to any one of claims 1 to 4, **characterized in that** the source and drain electrode metal thin film (6) is prepared by using a single film layer of any one of an aluminum thin film, a copper thin film, a molybdenum thin film, and a titanium thin film, or a composite film layer composed of at least two of the thin films, and the source and drain electrode metal thin film (6) is prepared in a thickness of 100 to 2000 nanometers.

11. The preparation method as claimed in claim 1, **characterized in that** removing or oxidizing the part of the metal nanoparticle layer (5) which is not covered by the source electrode (7) and the drain electrode (8) is performed by using oxygen plasma.

12. The preparation method as claimed in claim 1, **characterized in that** the passivation layer (9) is prepared by using a single film layer of any one of silicon oxide, silicon nitride, aluminum oxide, ytterbium oxide, polyimide, benzocyclobutene, and polymethyl methacrylate, or a composite film layer composed of at least two of silicon oxide, silicon nitride, aluminum oxide, ytterbium oxide, polyimide, benzocyclobutene, and polymethyl methacrylate, and the passivation layer (9) is prepared in a thickness of 50 to 2000 nanometers.

13. A thin film transistor, **characterized by** comprising:
a base substrate (1);
a gate electrode metal layer formed on the base substrate, wherein the gate electrode metal layer comprises a gate electrode (2);
a gate electrode insulating layer (3) formed on the gate electrode metal layer;
an active layer (4) formed on the gate electrode insulating layer (3);
a metal nanoparticle layer (5) formed on the active layer (4), wherein the metal nanoparticle layer (5) comprises at least one material of gold nanoparticles, silver nanoparticles, platinum nanoparticles, beryllium nanoparticles, nickel nanoparticles, and cobalt nanoparticles;
a source and drain electrode metal layer (6) formed on the metal nanoparticle layer (5), wherein the source and drain electrode metal layer (6) is a single film layer of any one of an aluminum thin film, a copper thin film, a molybdenum thin film, and a titanium thin film, or a composite film layer composed of at least two of the thin films; the source and drain electrode metal layer (6) comprises a source electrode (7) and a drain electrode (8); and the metal nanoparticle layer (5) is located below the source electrode (7) and the drain electrode (8); and
a passivation layer (9) formed on the source and drain electrode metal layer (6).

14. An array substrate, **characterized by** comprising the thin film transistor as claimed in claim 13.

15. A display panel, **characterized by** comprising an array substrate according to claim 14.

## Patentansprüche

1. Verfahren zur Herstellung eines Dünnschichttransistors, **dadurch gekennzeichnet, dass** es umfasst:
Bilden einer Gate-Elektroden-Metalldünnschicht auf einem Basissubstrat (1) und Ermöglichen, dass die Gate-Elektroden-Metalldünnschicht eine Gate-Elektroden-Metallschicht bildet, die eine Gate-Elektrode (2) umfasst, durch einen Strukturierungsvorgang;
Bilden einer Gate-Elektroden-Isolierschicht (3) auf der Gate-Elektroden-Metallschicht;
Bilden einer Metalloxid-Dünnschicht auf der Gate-Elektroden-Isolierschicht (3) und Ermöglichen, dass die Metalloxid-Dünnschicht ein Muster einer aktive Schicht (4) bildet, durch einen Strukturierungsvorgang;
Herstellen einer Metallnanopartikelschicht (5) auf der aktiven Schicht (4);
Bilden einer Source- und Drain-Elektroden-Metalldünnschicht (6) auf dem Basissubstrat, auf dem die obigen Vorgänge beendet sind, und Ermöglichen, dass die Source- und Drain-Elektroden-Metalldünnschicht (6) eine Source- und Drain-Elektroden-Metallschicht bildet, die eine Source-Elektrode (7) und eine Drain-Elektrode (8) aufweist, durch einen Strukturierungsvorgang, wobei die Metallnanopartikelschicht (5) beim Ätzen der Source- und Drain-Elektroden-Metalldünnschicht (6) als eine Ätzschutzschicht verwendet wird, und die sich ergebende Source-Elektrode (7) und Drain-Elektrode (8) einen Teil der Metallnanopartikelschicht (5) bedecken;
Entfernen oder Oxidieren des Teils der Metallnanopartikelschicht (5), der nicht von der Source-Elektrode (7) und der Drain-Elektrode (8) bedeckt ist, in einer sauerstoffhaltigen Atmosphäre; und
Bilden einer Passivierungsschicht (9) auf der Source- und Drain-Elektroden-Metallschicht (8).

2. Herstellungsverfahren nach Anspruch 1, **dadurch gekennzeichnet, dass** die Metallnanopartikelschicht (5) unter Verwendung mindestens eines Materials von Goldnanopartikeln, Silbernanopartikeln, Platinnanopartikeln, Berylliumnanopartikeln, Nickelnanopartikeln und Kobaltnanopartikeln hergestellt wird.

3. Herstellungsverfahren nach Anspruch 2, **dadurch gekennzeichnet, dass** das Herstellen der Metallnanopartikelschicht (5) auf der aktiven Schicht umfasst:
Herstellen der Metallnanopartikelschicht (5) auf der aktiven Schicht (4) unter Verwendung einer physikalischen Dampfabscheidung, einer chemischen Dampfabscheidung, eines hydrothermalen Verfahrens, eines Sol-Gel-Verfahrens, eines Sprühpyrolyseverfahrens oder eines Heißwandverfahrens.

4. Herstellungsverfahren nach Anspruch 2, **dadurch gekennzeichnet, dass** die Metallnanopartikelschicht (5) in einer Dicke von 1 bis 5 Nanometer hergestellt wird.

5. Herstellungsverfahren nach einem der Ansprüche 1 bis 4, **dadurch gekennzeichnet, dass** als das Basissubstrat (1) ein Glassubstrat verwendet wird, das eine Pufferschicht aufweist.

6. Herstellungsverfahren nach einem der Ansprüche 1 bis 4, **dadurch gekennzeichnet, dass** als das Basissubstrat (1) ein flexibles Substrat mit einer Wasser-Sauerstoff-Sperrschicht verwendet wird und dass als das Material des flexiblen Substrats Polyethylennaphthalat, Polyethylenterephthalat, ein Polyimid oder eine Metallfolie verwendet wird.

7. Herstellungsverfahren nach einem der Ansprüche 1 bis 4, **dadurch gekennzeichnet, dass** die Gate-Elektroden-Metalldünnschicht unter Verwendung einer einzelnen Filmschicht aus einer Aluminium-Dünnschicht, einer Kupfer-Dünnschicht, einer Molybdän-Dünnschicht, einer Titan-Dünnschicht, einer Silber-Dünnschicht, einer Dünnschicht aus Gold, einer Dünnschicht aus Tantal, einer Dünnschicht aus Wolfram, einer Dünnschicht aus Chrom und einer Dünnschicht aus einer Aluminiumlegierung oder einer Verbundfilmschicht, die aus mindestens zwei der Dünnschichten zusammengesetzt ist, hergestellt wird und die Gate-Elektroden-Metalldünnschicht in einer Dicke von 100 bis 2000 Nanometer hergestellt wird.

8. Herstellungsverfahren nach einem der Ansprüche 1 bis 4, **dadurch gekennzeichnet, dass** die Gate-Elektroden-Isolierschicht (3) unter Verwendung einer Monoschicht aus einer Siliciumoxid-Dünnschicht, einer Siliciumnitrid-Dünnschicht, einer Aluminiumoxid-Dünnschicht, einer Tantalpentoxid-Dünnschicht oder einer Ytterbiumoxid-Dünnschicht hergestellt wird, oder die Gate-Elektroden-Isolierschicht (3) unter Verwendung einer Verbund-Dünnschicht hergestellt wird, die aus mindestens zwei Monoschichten der Dünnschichten zusammengesetzt ist, und dass die Gate-Elektroden-Isolierschicht (3) in einer Dicke von 50 bis 500 Nanometer hergestellt wird.

9. Herstellungsverfahren nach einem der Ansprüche 1 bis 4, **dadurch gekennzeichnet, dass** die aktive Schicht (4) unter Verwendung eines Metalloxids, das mindestens eines von In, Zn, Ga und Sn enthält, hergestellt wird und dass die aktive Schicht (4) in einer Dicke von 10 bis 200 Nanometer hergestellt wird.

10. Herstellungsverfahren nach einem der Ansprüche 1 bis 4, **dadurch gekennzeichnet, dass** die Source- und Drain-Elektroden-Metalldünnschicht (6) unter Verwendung einer einzelnen Filmschicht aus einer Aluminium-Dünnschicht, einer Kupfer-Dünnschicht, einer Molybdän-Dünnschicht und einer Titan-Dünnschicht oder einer Verbundfilmschicht, die aus mindestens zwei von den Dünnschichten zusammengesetzt ist, hergestellt wird und die Source- und Drain-Elektroden-Metalldünnschicht (6) in einer Dicke von 100 bis 2000 Nanometer hergestellt wird.

11. Herstellungsverfahren nach Anspruch 1, **dadurch gekennzeichnet, dass** das Entfernen oder Oxidieren des Teils der Metallnanopartikelschicht (5), der nicht von der Source-Elektrode (7) und der Drain-Elektrode (8) bedeckt ist, unter Verwendung von Sauerstoffplasma durchgeführt wird.

12. Herstellungsverfahren nach Anspruch 1, **dadurch gekennzeichnet, dass** die Passivierungsschicht (9) unter Verwendung einer einzelnen Filmschicht aus einem von Siliciumoxid, Siliciumnitrid, Aluminiumoxid, Ytterbiumoxid, Polyimid, Benzocyclobuten und Polymethylmethacrylat, oder einer Verbundfilmschicht, die aus mindestens zwei von Siliziumoxid, Siliziumnitrid, Aluminiumoxid, Ytterbiumoxid, Polyimid, Benzocyclobuten und Polymethylmethacrylat zusammengesetzt ist, hergestellt wird und dass die Passivierungsschicht (9) in einer Dicke von 50 bis 2000 Nanometer hergestellt wird.

13. Dünnschichttransistor, **dadurch gekennzeichnet, dass** er aufweist:
ein Basissubstrat (1);
eine Gate-Elektroden-Metallschicht, die auf dem Basissubstrat gebildet ist, wobei die Gate-Elektroden-Metallschicht eine Gate-Elektrode (2) aufweist;
eine Gate-Elektroden-Isolierschicht (3), die auf der Gate-Elektroden-Metallschicht gebildet ist;
eine aktive Schicht (4), die auf der Gate-Elektroden-Isolierschicht (3) gebildet ist;
eine Metallnanopartikelschicht (5), die auf der aktiven Schicht (4) gebildet ist, wobei die Metallnanopartikelschicht (5) mindestens ein Material aus Goldnanopartikeln, Silbernanopartikeln, Platinnanopartikeln, Berylliumnanopartikeln, Nickelnanopartikeln und Kobaltnanopartikeln umfasst;
eine Source- und Drain-Elektroden-Metallschicht (6), die auf der Metallnanopartikelschicht (5) gebildet ist, wobei die Source- und Drain-Elektroden-Metallschicht (6) eine einzelne Filmschicht aus einer Aluminium-Dünnschicht, einer Kupfer-Dünnschicht, einer Molybdän-Dünnschicht und einer Titan-Dünnschicht ist oder eine Verbundfilmschicht ist, die aus mindestens zwei der Dünnschichten zusammengesetzt ist; die Source- und Drain-Elektroden-Metallschicht (6) eine Source-Elektrode (7) und eine Drain-Elektrode (8) umfasst; und die Metallnanopartikelschicht (5) unterhalb der Source-Elektrode (7) und der Drain-Elektrode (8) angeordnet ist; und
eine Passivierungsschicht (9), die auf der Source- und Drain-Elektroden-Metallschicht (6) gebildet ist.

14. Arraysubstrat, **dadurch gekennzeichnet, dass** es den Dünnschichttransistor nach Anspruch 13 umfasst.

15. Anzeigetafel, **dadurch gekennzeichnet, dass** sie ein Arraysubstrat nach Anspruch 14 umfasst.

## Revendications

1. Procédé de préparation d'un transistor à couches minces, **caractérisé en ce qu'**il comprend :
le formage d'un film mince métallique d'électrode de grille sur un substrat de base (1) et le fait de permettre au film mince métallique d'électrode de grille de former une couche métallique d'électrode de grille comprenant une électrode de grille (2) par un processus de modélisation ;
le formage d'une couche isolante d'électrode de grille (3) sur la couche métallique d'électrode de grille ;
le formage d'un film mince d'oxyde métallique sur la couche isolante d'électrode de grille (3), et le fait de permettre au film mince d'oxyde métallique de former un modèle d'une couche active (4) par un processus de modélisation ;
la préparation d'une couche de nanoparticules métalliques (5) sur la couche active (4) ;
le formage d'un film mince métallique d'électrode de source et de drain (6) sur le substrat de base sur lequel les processus ci-dessus sont finis, et le fait de permettre au film mince métallique d'électrode de source et de drain (6) de former une couche métallique d'électrode de source et de drain comprenant une électrode de source (7) et une électrode de drain (8) par un processus de modélisation, la couche de nanoparticules métalliques (5) étant utilisée comme couche de protection anti-attaque lorsque le film mince métallique d'électrode de source et de drain (6) est attaqué, et l'électrode de source résultante (7) et l'électrode de drain (8) couvrant une partie de la couche de nanoparticules métalliques (5) ;
l'élimination ou l'oxydation de la partie de la couche de nanoparticules métalliques (5) qui n'est pas couverte par l'électrode de source (7) et l'électrode de drain (8) dans une atmosphère contenant de l'oxygène ; et
le formage d'une couche de passivation (9) sur la couche métallique d'électrode de source et de drain (8).

2. Procédé de préparation selon la revendication 1, **caractérisé en ce que** la couche de nanoparticules métalliques (5) est préparée en utilisant au moins un matériau parmi des nanoparticules d'or, des nanoparticules d'argent, des nanoparticules de platine, des nanoparticules de béryllium, des nanoparticules de nickel, et des nanoparticules de cobalt.

3. Procédé de préparation selon la revendication 2, **caractérisé en ce que** la préparation de la couche de nanoparticules métalliques (5) sur la couche active comprend :
la préparation de la couche de nanoparticules métalliques (5) sur la couche active (4) en utilisant un dépôt de vapeur en phase physique, un dépôt de vapeur en phase chimique, un procédé hydrothermique, un procédé sol-gel, un procédé de pyrolyse par pulvérisation, ou un procédé à paroi chaude.

4. Procédé de préparation selon la revendication 2, **caractérisé en ce que** la couche de nanoparticules métalliques (5) est préparée dans une épaisseur de 1 à 5 nanomètres.

5. Procédé de préparation selon l'une quelconque des revendications 1 à 4, **caractérisé en ce qu'**un substrat en verre comportant une couche tampon est utilisé comme substrat de base (1).

6. Procédé de préparation selon l'une quelconque des revendications 1 à 4, **caractérisé en ce qu'**un substrat souple comportant une couche barrière eau-oxygène est utilisé comme substrat de base (1), et que du naphtalate de polyéthylène, du téréphtalate de polyéthylène, un polyimide, ou un film métallique est utilisé comme matériau du substrat souple.

7. Procédé de préparation selon l'une quelconque des revendications 1 à 4, **caractérisé en ce que** le film mince métallique d'électrode de grille est préparé en utilisant une seule couche de film quelconque parmi un film mince d'aluminium, un film mince de cuivre, un film mince de molybdène, un film mince de titane, un film mince d'argent, un film mince d'or, un film mince de tantale, un film mince de tungstène, un film mince de chrome, et un film mince d'alliage d'aluminium, ou si le une couche de film composite composée d'au moins deux des films minces, et que le film mince métallique d'électrode de grille est préparé dans une épaisseur de 100 à 2000 nanomètres.

8. Procédé de préparation selon l'une quelconque des revendications 1 à 4, **caractérisé en ce que** la couche isolante d'électrode de grille (3) est préparée en utilisant une monocouche d'un film mince d'oxyde de silicone, d'un film mince de nitrure de silicone, d'un film mince d'oxyde d'aluminium, d'un film mince de pentoxyde de tantale, ou d'un film mince d'oxyde d'ytterbium, que la couche isolante d'électrode de grille (3) est préparée en utilisant un film mince composite composé d'au moins deux monocouches des films minces, et que la couche isolante d'électrode de grille (3) est préparée dans une épaisseur de 50 à 500 nanomètres.

9. Procédé de préparation selon l'une quelconque des revendications 1 à 4, **caractérisé en ce que** la couche active (4) est préparée en utilisant un oxyde métallique contenant au moins un élément parmi les In, Zn, Ga, et Sn, et que la couche active (4) est préparée dans une épaisseur de 10 à 200 nanomètres.

10. Procédé de préparation selon l'une quelconque des revendications 1 à 4, **caractérisé en ce que** le film mince métallique d'électrode de source et de drain (6) est préparé en en utilisant une seule couche de film quelconque parmi un film mince d'aluminium, un film mince de cuivre, un film mince de molybdène, et un film mince de titane, ou un film composite composé d'au moins deux des films minces, et que le film mince métallique d'électrode de grille (6) est préparé dans une épaisseur de 100 à 2000 nanomètres.

11. Procédé de préparation selon la revendication 1, **caractérisé en ce que** l'élimination ou l'oxydation de la partie de la couche de nanoparticules métalliques (5) qui n'est pas couverte par l'électrode de source (7) et l'électrode de drain (8) est réalisée en utilisant du plasma d'oxygène.

12. Procédé de préparation selon la revendication 1, **caractérisé en ce que** la couche de passivation (9) est préparée en utilisant une seule couche de film quelconque parmi un film mince d'oxyde de silicone, de nitrure de silicone, d'oxyde d'aluminium, d'oxyde d'ytterbium, de polyimide, de benzocyclobutène, et de polyméthyle métacrylate, ou une couche de film composite composée d'au moins deux éléments parmi l'oxyde de silicone, le nitrure de silicone, l'oxyde d'aluminium, l'oxyde d'ytterbium, le polyimide, le benzocyclobutène, et e polyméthyle métacrylate, et que la couche de passivation (9) est préparée dans une épaisseur de 50 à 2000 nanomètres.

13. Transistor à film mince, **caractérisé en ce qu'**il comprend :
un substrat de base (1) ;
une couche métallique d'électrode de grille formée sur le substrat de base, la couche métallique d'électrode de grille comprenant une électrode de grille (2) ;
une couche isolante d'électrode de grille (3) formée sur la couche métallique d'électrode de grille ;
une couche active (4) formée sur la couche isolante d'électrode de grille (3) ;
une couche de nanoparticules métalliques (5) formée sur la couche active (4), la couche de nanoparticules métalliques (5) comprenant au moins un matériau parmi des nanoparticules d'or, des nanoparticules d'argent, des nanoparticules de platine, des nanoparticules de béryllium, des nanoparticules de nickel, et des nanoparticules de cobalt ;
une couche métallique d'électrode de source et de drain (6) formée sur la couche de nanoparticules métalliques (5), la couche métallique d'électrode de source et de drain (6) étant une seule couche de film quelconque parmi un film mince d'aluminium, un film mince de cuivre, un film mince de molybdène, et un film mince de titane, ou une couche composite composée d'au moins deux des films minces ; la couche métallique d'électrode de source et de drain (6) comprenant une électrode de source (7) et une électrode de drain (8) et la couche de nanoparticules métalliques (5) se trouvant en dessous de l'électrode de source (7) et de l'électrode de drain (8) ; et
une couche de passivation (9) formée sur la couche métallique d'électrode de source et de drain (6).

14. Substrat de matrice, **caractérisé en ce qu'**il comprend le transistor à couches minces selon la revendication 13.

15. Panneau d'affichage, **caractérisé en ce qu'**il comprend le substrat de matrice selon la revendication 14.
